# EUROPEAN PATENT APPLICATION

(11) **EP 4 752 742 A1**
(43) Date of publication of application: **03.06.2026**
(21) Application number: 24216495.2
(22) Date of filing: 29.11.2024
(51) Int. Cl.: G06F 15/78

(54) **INTEGRATED CIRCUIT DEVICE**

(71) Applicant: Imec VZW, 3001 Leuven (BE)
(72) Inventor: MYERS, James Edward, Great Wibraham, CB21 5JD (GB); BRUNION, Moritz, 3001 Heverlee (BE)
(74) Representative: Lind Edlund Kenamets Intellectual Property AB

(57) **Abstract**

The present invention relates in an aspect to an integrated circuit device. The integrated circuit device comprises an active device tier and a frontside interconnect structure arranged at a frontside of the active device tier and a backside interconnect structure arranged at a backside of the active device tier. The integrated circuit device comprises a plurality of circuit blocks, and a data communication circuit configured to transfer data between the plurality of circuit circuit blocks. The data communication circuit comprises a plurality of switching circuits. Each circuit circuit block is connected to the data communication circuit by a switching circuit. The data communication circuit further comprises a plurality of data communication channels interconnecting the plurality of switching circuits and comprising a plurality of backside interconnects arranged in one or more interconnect layers of the backside interconnect structure.

## Description

### TECHNICAL FIELD

The present invention generally relates to an integrated circuit (IC) device with a data communication circuit being a network-on-chip (NoC) circuit or a ringbus circuit, and configured to transfer data between the plurality of circuit blocks.

### BACKGROUND

Many-core systems, such as systems-on-chip (SoC) implementations with a plurality of processing cores, often use mesh network topologies like a mesh topology network-on-chip (NoC) to create multiple routes for information to travel among connected nodes. These networks may for instance be implemented in many-processor systems to interconnect processing cores and/or memory blocks and facilitate efficient data transfer across IC devices.

While the NoC topology provides a flexible and scalable data communication fabric, present implementations use sparsely populated routing channels that consume a significant part of on-chip resources with up to 10% of chip area.

Advances in fabrication of integrated circuits (ICs) has this far allowed an ongoing downscaling of active device sizes and pitch of lower interconnect metal layers in the back-end-of-line (BEOL). However, for many-core systems, the NoC is about to become a potential scaling limiter, one reason being that aggressively scaling the metal pitches of the metal layers used by the NoC, to follow the density scaling of the computational logic would considerably increase the unit resistance. Increasing number of cores per chip is further linked with an increase in the number of signals per NoC channel to maintain the throughput rate for the same frequency, and an increased latency due to a larger core grid size.

This ongoing challenge motivates further efforts and improvements in the design and fabrication of ICs, to enable a scaling path for many-core systems comprising inter-core data communication circuits, such as the NoC.

### SUMMARY

In view of the above, it is thus an object of the present invention to provide an improved design of an IC device, enabling a scaling path for many-core systems comprising an inter-core data communication circuit, such as a NoC.

These objects are achieved by different aspects and embodiments herein as defined in the appended set of independent and dependent claims.

According to an aspect of the present invention, there is provided an integrated circuit (IC) device. The IC device comprises an active device tier and a frontside interconnect structure arranged at a frontside of the active device tier, and a backside interconnect structure arranged at a backside of the active device tier. The IC device further comprises a plurality of circuit blocks. Each circuit block comprises a first set of active devices comprised in the active device tier. The first set of active devices are interconnected by the frontside interconnect structure. The IC device further comprises a data communication circuit configured to transfer data between the plurality of circuit blocks. The data communication circuit is a network-on-chip, NoC, circuit or a ringbus circuit. The data communication circuit comprises a plurality of switching circuits. Each switching circuit comprises a second set of active devices comprised in the active device tier, where the second set of active devices are connected by the frontside interconnect structure. Each circuit block is connected to the data communication circuit by a switching circuit. The data communication circuit further comprises a plurality of data communication channels interconnecting the plurality of switching circuits. The plurality of data communication channels comprise a plurality of backside interconnects arranged in one or more interconnect layers of the backside interconnect structure.

To facilitate the following discussion, reference will in the following be made to "My metal layers" and "Mx metal layers". The term "My metal layers" is hereby used to denote one or more upper level metal layers of a frontside BEOL interconnect structure, which typically are formed with a greater pitch. The term "Mx metal layers" is meanwhile used to denote one or more lower level metal layers of the frontside BEOL interconnect structure, which typically are formed with a smaller pitch than the My metal layers. The Mx metal layers may also be referred to as the local interconnect layers, i.e., the metal layers connected to / interacting with the front-end-of-line (FEOL) structures (e.g., active devices) at the local interconnect level.

Conventional NoC implementations utilize the frontside BEOL interconnect structure of the ICs for distribution and routing of data between the cores. The data communication signals are typically routed in the My metal layers of the frontside interconnect structure as a trade-off between wire density and RC delay ("R" denoting resistance per unit length and "C" denoting capacitance per unit length). The line width and pitch of these My metal layers may for example be multiples of the minimum width and pitch of the Mx metal layers, e.g. 2x or 3x, in order to reduce unit resistance and propagation delays.

Since current frontside BEOL scaling focuses on the Mx metal layers , and there is no projected reduction of My pitch, there is no intrinsic area scaling of the NoC channels implemented in the My layer. Moreover, in the many-core systems with a growing number of cores it may still be necessary to increase the number of signal routes and routing channels to maintain memory bandwidth per core, which inevitably results in increasing the on-chip area of the data communication channels.

The present invention is at least partly based on a realization that disintegrating the NoC channels of the NoC circuit from the frontside BEOL to the backside BEOL structure, significantly reduces the competition for routing resources in the frontside interconnect structure. In this way, constraints associated with metal line characteristics for the interconnects of the NoC channels, i.e., minimum width, pitch and separation requirements, are offloaded to the backside interconnect structure with a more relaxed metal layer width and pitch requirements. This also avoids the My metal layers of the frontside BEOL to be occupied by metal lines with the certain minimum width metal line requirements associated with the NoC channels, thus allowing utilization of these resources for other purposes.

Although the above discussion has referred mainly to data communication circuits in the form of NoC circuits, it is contemplated to also be applicable to data communication circuits realized by a ringbus circuit. Thus, the merits of the IC device of the first aspect outlined above with reference to a NoC circuit may apply correspondingly to a ringbus circuit.

In some embodiments, each data communication channel may comprise a respective subset of backside interconnects of the plurality of backside interconnects. Moreover, each data communication channel may comprise a plurality of repeater islands arranged at intervals along the data communication channel. Each repeater island comprises a third set of active devices comprised in the active device tier. The repeater islands of the data communication channel may be connected in sequence by the respective subset of backside interconnects.

In some embodiments, the data communication circuit is the NoC circuit. The plurality of data communication channels may thus be a set of NoC channels comprising a first and second subset of NoC channels. The first subset of NoC channels may extend in parallel in a row direction, and the second subset of NoC channels may extend in parallel in a column direction transverse to the row direction.

The NoC circuit comprising backside metal interconnects and arranged in a mesh topology as disclosed herein provides benefits such as scalability in connecting a large number of circuit blocks over long distances (e.g., CPU cores and memory blocks or other macro-elements), making it an ideal choice for the many-core SoC. Accordingly, high data throughput may be achieved by efficiently managing the data traffic, while reducing the footprint of the NoC circuit and overall wafer costs.

In some embodiments, the plurality of circuit blocks may be distributed in the row and column directions, along the first and second subset of NoC channels.

In some embodiments, the plurality of circuit blocks may be arranged in a plurality of tiles. The plurality of tiles may be arranged in a plurality of rows and columns, wherein the first and second subset of NoC channels may extend along boundaries between the tiles.

In some embodiments, the plurality of switching circuits may be NoC routers. Each NoC router may be arranged at a respective cross-point between the first and second subset of NoC channels.

In some embodiments, each of the one or more interconnect layers of the backside interconnect structure comprising the plurality of backside interconnects may be a bidirectional interconnect layer. Each bidirectional interconnect layer may comprise metal lines extending in a row direction and in a column direction transverse to the row direction.

Conventionally, the multi-layered interconnect architecture comprises unidirectional metal lines. Each metal layer may be dedicated to lines running and carrying signals in a single direction, with alternating layers oriented orthogonally to each other. In a unidirectional implementation, the number of metal layers required to implement the data communication network, e.g., the NoC circuit is doubled. Further, the unidirectional implementation has the disadvantage that it creates a direction-specific multi-layer blockage for other signals.

However, utilizing one or more bidirectional interconnect layers, data traffic signals can be propagated throughout the data communication network of the IC device in a bidirectional manner within each bidirectional interconnect layer.

In some embodiments, the plurality of backside interconnects of the communication channels may be arranged in two or more bidirectional interconnect layers of the backside interconnect structure comprising metal lines extending in the row direction and in the column direction transverse to the row direction.

One benefit of implementing the backside interconnects in at least two backside interconnect layers is that the footprint of the switching circuits, e.g., the NoC routers and the repeater islands can be further reduced. Furthermore, clock signals may be routed in the backside interconnect structure, as will be described in various aspects herein, with a higher degree of freedom accounting for irregularities in the routing of the clock signals to the respective circuit blocks.

In some embodiments, the IC device may further comprise a clock distribution network comprising a plurality of backside clock interconnects. The plurality of backside clock interconnects may be arranged in the one or more interconnect layers of the backside interconnect structure. The plurality of backside clock interconnects may be connected to the plurality of circuit blocks to distribute clock signals to the plurality of circuit blocks.

A conventional approach for clock distribution is to route the clock signal at the frontside interconnect structure. However, the present inventors have realized that the clock signals may instead be routed using the backside interconnect structure and alongside the backside data communication channels.

A benefit of backside routing of the clock signal is that competition for routing resources in the frontside interconnect structure may be further reduced.

In some embodiments, the plurality of backside clock interconnects may be arranged in the two or more bidirectional interconnect layers.

In some embodiments, the clock distribution network may further comprise, for each tile, a respective network portion of the clock distribution network arranged in the two or more bidirectional metal layers of the backside interconnect structure. The respective network portion may be arranged within a footprint of the tile and be connected to one or more circuit blocks of the respective tile.

Due to the spatial separation between the network portions of the clock distribution network and the data routing metal layers, the clock portions and NoC interconnects may be implemented in the same bidirectional metal layers. Accordingly, the available routing resources of the bidirectional metal layers not used for the data communication channels may be utilized more efficiently. This way, a seamless co-integration of the clock routing with the backside data channel routing is achieved without requiring additional designated clock routing metal layers in the backside interconnect.

In some embodiments, the data communication circuit may be a ringbus circuit. The plurality of communication channels of the ringbus circuit may be comprised in a plurality of ringbus segments, wherein a switching circuit may be arranged between two adjacent ringbus segments.

In some embodiments, the IC device may further comprise a power distribution network (PDN) arranged in the backside interconnect structure.

In some embodiments, the PDN may be arranged in at least a first and second backside interconnect layer. The one or more interconnect layers of the backside interconnect structure comprising the plurality of backside interconnects of the communication channels may be arranged between at least the first and second backside interconnect layers. Furthermore, the plurality of backside clock interconnects may also be arranged between at least the first and second backside interconnect layers of the PDN.

Since the NoC or ringbus channel routes require a low unit RC to drive long wires at a high clock frequency, the NoC and ringbus routes lend themselves favorably for co-integration alongside the backside PDN.

In some embodiments, the IC device may comprise a die having a backside and a frontside. Accordingly, the active device tier may be arranged on the frontside of the die, and the backside interconnect structure may be arranged opposite the active device tier on the backside of the die.

These and other aspects of the disclosure will become clearer upon reviewing the detailed description that follows. Additional aspects, features, and implementations will be evident to those skilled in the art after examining the specific implementations described in conjunction with the accompanying figures. Although features of the disclosure may be discussed in relation to certain implementations and figures, all implementations can incorporate one or more of the advantageous features mentioned herein. In other words, while certain implementations may highlight specific advantageous features, these features can be applied across various implementations of the disclosure.

### BRIEF DESCRIPTION OF THE DRAWINGS

This and other aspects of the present invention will now be described in more detail, with reference to the appended drawings. The drawings are only schematic and the relative dimensions of some structures and layers may be exaggerated and not drawn to scale. Rather the dimensions may be adapted for illustrational clarity and to facilitate understanding.
Figs. 1a-b schematically depict respective cross-sectional side views of two variants of an integrated circuit device according to some embodiments of the present disclosure.
Fig. 2 shows a schematic top view of a portion of a floorplan of the IC device according to some embodiments of the present disclosure.
Fig. 3a shows a schematic top view of a portion of an array of the IC device in Fig. 2 according to some embodiments of the present disclosure.
Fig. 3b shows a cross-sectional side view of the IC device according to some embodiments of the present disclosure.
Fig. 4 shows a schematic top view of another portion of an array of the IC device in Fig. 2 according to yet another embodiment of the present disclosure.
Fig. 5 shows yet another cross-sectional side view of the IC device according to some embodiments of the present disclosure.
Figs. 6a-b schematically depict a perspective view and a top view of the IC device according to some embodiments of the present disclosure.

### DETAILED DESCRIPTION

The following disclosure presents various embodiments or examples for implementing different aspects of the provided subject matter. Specific examples of components and arrangements of the IC device are described to simplify the disclosure. These examples are not intended to be limiting. For instance, the description of a first feature, e.g. a frontside interconnect layer formed over or on a second feature e.g., an active device tier may include embodiments where the first and second features are in direct contact, as well as embodiments where additional connecting layers are formed between them. Additionally, reference numerals and/or letters may be repeated in various examples for simplicity and clarity, without implying a specific relationship between the different embodiments and/or configurations discussed.

It is noted that spatially relative terms such as "beneath," "below," "lower," "above," "over," "under," "upper," "top," "bottom," "frontside," "backside," and similar terms are used for ease of description to indicate the relationship of one element or feature to another as shown in the figures. Since components in various embodiments can be oriented in multiple ways, the directional terminology is used for illustrative purposes only and is not limiting. When referring to layers of an integrated circuit device, the directional terminology is meant to be interpreted broadly, allowing for the presence of one or more intervening layers or features. Therefore, an element (e.g. a backside or frontside interconnect structure, a contact, a layer such as the active device layer or other structure) described as being formed on, over, or under another element, may be separated by one or more intermediate layers unless specified otherwise. For instance, an element disposed "on" another element, can be directly on the other element or on one or more intermediate elements on the other element. Similarly, in the present context when a first component is described to be connected to a second component, it is meant that the first component may be connected to the second component directly, or indirectly through one or more intermediate components.

When present in the figures, the indicated axes X and Y consistently refer to a first horizontal, and a second horizontal in a common (2D) plane.

As used herein, the term "horizontal" refer to directions parallel to a main plane of extension of a device tier, a die or substrate. For instance, a horizontal direction is parallel to a main surface, e.g., a frontside of an active device tier or a frontside of a die of the IC device.

Accordingly in the figures, a "row" direction corresponds to the first horizontal direction, and the "column" direction corresponds to the second horizontal direction transverse to the row direction. Stated differently, the row and column directions are transverse in-plane directions parallel to the main surface of the active device tier or the die of the IC device.

The axis Z, when present, denotes a "vertical" direction. The term vertical is here to be construed as a direction normal or perpendicular to the horizontal XY-plane, or equivalently, an out-of-plane direction normal or perpendicular to the main surface of the active device tier or the die.

Accordingly, terms indicating relative vertical arrangement of elements, such as "top", "upper", "bottom", "lower" and the like, are to be understood in relation to the vertical direction.

It is further to be noted that terms such as "first" and "second" etc. with reference to elements (e.g. layers or other structures) or steps may be used herein as labels to facilitate distinguishing between different elements and need not necessarily imply that such elements or steps are arranged or performed in that particular order, unless stated otherwise.

The term "FEOL structure" is herein to be construed as a portion of an IC device comprising active devices, e.g., an active layer of the die (i.e., comprising the active regions or patterns of the active devices, e.g., transistors), a gate layer (i.e., comprising the gates of the frontend transistors). The FEOL structure may further comprise a local contact layer (i.e., comprising the source/drain (S/D) contacts of the transistors). The active regions may comprise S/D regions and channel regions of the transistors. The active layer may be formed in a semiconductor substrate of the die.

The term "BEOL interconnect structure" (or simply "interconnect structure") herein is to be construed as a multi-layered stack of interconnect layers, each comprising a metal layer embedded in dielectrics and comprising horizontally routed metal interconnects (conductive traces or lines), simply referred to as metal lines. Vertically routed interconnects ("vias") or metal-filled vias are orthogonally positioned to provide connectivity between the stack of interconnect layers. In the present context, the BEOL interconnect structure on the frontside of the active device tier or the die will be referred to as the "frontside interconnect structure". The BEOL interconnect structure arranged on the backside of the active device tier, or the die may be referred to as the "backside interconnect structure".

The term "via interconnect" or "via structure" is here used to refer to any conductive element configured for vertical signal routing through the interconnect structures or between the interconnect structures and the active device tier.

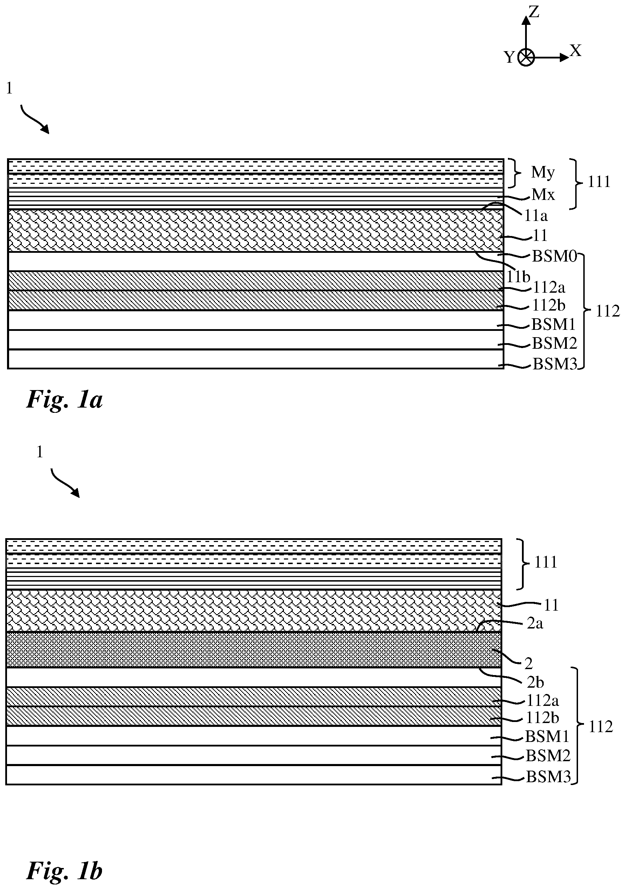

Fig. 1a schematically depicts a cross-sectional side view of a portion of an integrated circuit (IC) device 1. The IC device 1 may be a multi- or many-core SoC device 1. Herein, the term multi-core may be used to refer to systems with two to eight processing cores (or processing elements). Many-core may be used to refer to systems with more than eight processing cores (or processing elements) and which may have, for example, twenty or thirty or hundreds of processing cores. The IC device 1 may for instance be a cloud server SoC comprising a plurality of CPU cores such as 80, 128, 192, cores and so on. This is however merely a non-limiting example of a possible use case for the IC device 1 and other use cases are also possible.

The IC device 1 comprises an active device tier 11. The active device tier 11 comprises active devices (not specifically shown) of the IC device 1. The active device tier 11 as described throughout this description forms a part of the FEOL structure of the IC device 1 comprising the active regions and the frontend transistors of the IC device 1.

The IC device 1 further comprises a frontside (BEOL) interconnect structure 111 and a backside (BEOL) interconnect structure 112. The active device tier 11 has a frontside 11a and a backside 11b. The frontside interconnect structure 111 is arranged at the frontside 11a of the active device tier 11 and the backside interconnect structure 112 is arranged at the backside 11b of the active device tier 11. The frontside interconnect structure 111 faces away from the backside interconnect structure 112 and is configured to interconnect the active devices comprised in the active device tier 11.

It is noted that the frontside 11a and the backside 11b of the active device tier 11 also may be referred to as a first side 11a and a second side 11b of the active device tier 11 respectively. Typically, the frontside / first side 11a may refer to the side of a die 2 (discussed below) of the IC device 1 on which the active devices are formed. Correspondingly, the backside / second side 11b may refer to the side of the die 2 opposite the frontside / first side 11a.

By way of example, the stack layers of the frontside interconnect structure 111 are denoted Mx and My (metal) layers. The Mx layers, may be lower metal layers positioned over the FEOL structure and used for locally interconnecting active devices. The Mx layers may be characterized by their fine pitch and high density, facilitating short-range connections between transistors in the FEOL structure. The My layers are typically positioned above with respect to the Mx layers and may serve as intermediate or semi-global interconnects. Via interconnects of the frontside interconnect structure 111 may be arranged to provide connectivity between the Mx and My layers and the frontend active devices. The Mx and My layers may further each be multi-layer structures, structural details of which are largely omitted in this description and are presumed to be known to a skilled person in the art. It should be noted that the frontside interconnect structure may comprise further interconnect layers, such as one or more Mz layers, as well as a redistribution layer (RDL), each having more relaxed width and pitch requirements.

The metal stack layers of the backside interconnect structure 112, are denoted BSM0, 112a, 112b, BSM1, BSM 2, and BSM3. These routing layers are also only shown as an example of illustrating the multi-layered backside BEOL structure. It should be clear that each of the frontside or backside interconnect structures112 may have a different number of layers than shown in the figures. The BMSO layer is the topmost backside metal layer (i.e., the backside metal layer closest to the active device tier 11), and the BMS3 layer is the bottommost layer of the backside interconnect structure 112 positioned below intermediate backside metal layers BSM 1 - 2 in Fig. 1a.

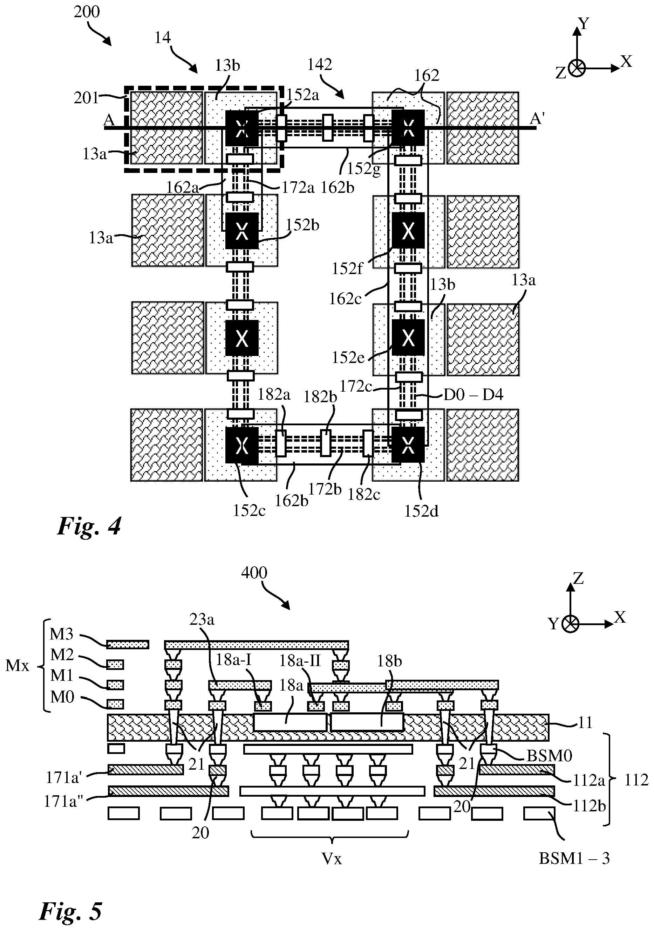

Layers 112a and 112b in this example are two successive backside interconnect layers arranged between the backside metal layers labeled BMS 0 - 3. It should be appreciated that the order in which layers 112a, 112b and the backside metal layers BMS 0 - 3 are depicted is also an example and other layer arrangements of metal layers in the backside interconnect structure 112 is also possible. For example, layers BSM0 and BSM1 may be arranged on top, and layers BSM2 and BSM3 may be arranged underneath the layers 112a, 112b. The layers 112a, and 112b serve as backside interconnect layers for routing data traffic and clock signals in the IC device 1 according to various implementations and embodiments of the present disclosure as will be explained further in the following. It should be appreciated that even though Figs. 1a only depict two layers of interconnect layers 112a, b, any number of backside interconnect layers, such as three or more interconnect layers may be readily implemented based on the design requirements of the backside interconnect structure 112. The multiple backside metal layers may be orthogonally interconnected by means of orthogonal via interconnect layers comprised in the backside interconnect structure 112, e.g., as shown in the example of Figs. 4a and 4b.

In the present context, the frontside 11a of the active device tier 11 faces the frontside interconnect structure 111, for instance the lowest Mx layer of the frontside interconnect structure 111, which is arranged on top of the active device tier 11. Accordingly, the backside 11b of the active device tier 11 is an opposing side to the frontside 11a of the active device tier 11, facing away from the frontside interconnect structure 111, i.e., facing the backside interconnect structure 112. For instance, the topmost layer BSM0 of the backside interconnect structure 112 is disposed beneath the backside 11b of the active device tier 11.

The backside metal layers may have dimensions based on the design of the IC device. For optimizing wire density and performance requirements of IC devices in a given implementation, the interconnect metal lines in the interconnect layers typically have separation, minimum pitch (the smallest center-to-center distance between adjacent metal lines), and minimum width (the smallest allowable width of metal lines, affecting resistance and capacity of the metal line) requirements. For instance, in example implementations herein, the BSM0 layer may have a minimum pitch, width, and separation of 80 nm, 53 nm, and 28 nm respectively. Layers BMS1 - 3 may have more relaxed constraints, such as a minimum pitch, width and spacing 320 nm, 160 nm, and 160 nm, respectively. Further BSM1 - 3 layers may have even more relaxed constraints, such as a minimum pitch, width and separation of 1080 nm, 540 nm, and 540 nm, respectively. The interconnect layers 112a, b may for instance have a minimum width, pitch and separation of 80 nm, 80 nm and 160 nm, respectively.

Fig. 1b shows a further depiction of the IC device 1, further comprising a die 2 having a backside 2a and a frontside 2b. The die 2 may be a conventional substrate suitable for CMOS circuits and semiconductor device processing. The die 2 may for instance comprise a semiconductor substrate of Si, Ge or SiGe. Other non-limiting examples include a silicon-on-insulator (SOI) substrate, a GeOI substrate or a SiGeOI substrate. The FEOL structure of the IC device including the active device tier 11 may thus be fabricated on the semiconductor substrate such that the active device tier 11 is arranged on the frontside 2a of the die 2, and the backside interconnect structure 112 is arranged opposite the active device tier 11 on the backside 2b of the die 2. The backside interconnect structure 112 on the backside 2b of the die 2 faces away from the frontside interconnect structure 111 arranged on the frontside 2a of the die 2.

For example, the structure of the IC device 1 shown in Fig. 1a may be arrived at by applying substrate thinning such that the substrate on which the active device tier 11 initially is formed, is substantially removed, prior to forming the backside interconnect structure. It is noted that all features and advantages discussed in relation to either the IC device 1 of Fig. 1a or 1b apply correspondingly to the other IC device 1.

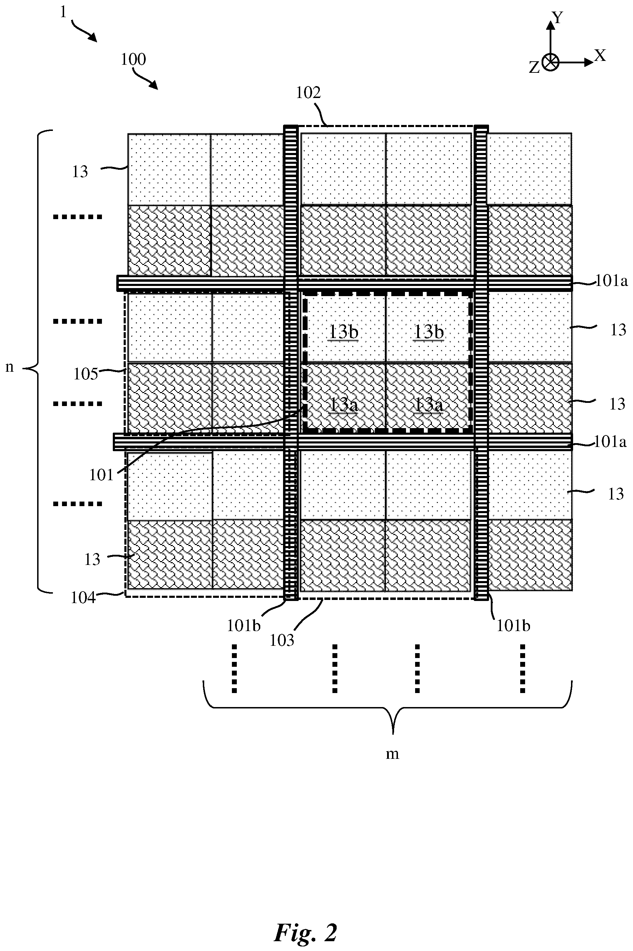

The IC device 1 of Fig. 1a and 1b further comprises a plurality of circuit blocks 13 as shown and further described in the following with further reference to Fig. 2. Each circuit block 13 comprises a first set of active devices, e.g., a first set of frontend transistors, etc. (not specifically shown) comprised in the active device tier 11. The first set of active devices are interconnected by the frontside interconnect structure 111. The circuit blocks in the present context are to be construed as fundamental units within the IC device designed to perform specific circuit tasks such as arithmetic operations, processing data, control units for managing and executing instructions, memory units for storing data and instructions, Input/Output (I/O) units for managing data exchange between various units, and the like.

Fig. 2 illustrates a schematic top view of a portion of a floorplan of the IC device 1 as viewed (in absence of the frontside interconnect structure 111) from the frontside 11a of the active device tier 11 in Figs. 1a or 1b. The depicted portion comprises an array 100 of plurality of circuit blocks 13. The plurality of circuit blocks 13 are distributed in a row direction (X direction) and a column direction (Y direction) extending transverse to the row direction, as denoted by the dotted lines extending in XY directions on the peripheries of the array 100.

Accordingly, the plurality of computation circuit blocks 13 are arranged in a plurality of rows and columns of the array 100. As mentioned earlier, each computation circuit block 13 comprises the first set of active devices that are comprised in the active device tier 11 and interconnected by the frontside interconnect structure 111. The depicted array 100 has an array dimension of (n x m) with "n" rows and "m" columns comprising respective number of circuit blocks 13, with "n" and "m" being integers indicating the array dimensions in the row and column directions.

It should be appreciated that the IC device 1 may comprise a floorplan having one or more arrays of any desired dimensions. The one or more arrays of circuit blocks 13 may have identical or different dimensions in the respective row and column directions, e.g. the IC device 1 may comprise one or more 8 x 8 or 16 x 16 arrays or the like. Any specific array dimensions, and number of circuit blocks 13 in the figures herein are merely provided by way of example, and as will be realized by the skilled person in the art, other array layouts are also possible. It should also be appreciated that even though not depicted herein, other IC device components such as peripheral logic, or other circuit blocks such as control circuits, etc. may be arranged between the circuit blocks 13 in the arrays. Furthermore, empty spaces may be present between the circuit blocks 13 in each row and column.

The circuit blocks 13 may comprise various circuits including processing units such as general purpose or application-specific processor cores (e.g., CPUs, GPUs, accelerators, etc.), intellectual property (IP) cores, memory circuit blocks (e.g., SRAM, DRAM, Cache), I/O (input/output) devices, etc.

The plurality of circuit blocks 13 may as depicted in Fig. 2 be arranged in a plurality of tiles forming a tiled structure. The tiled structure comprises a plurality of tiles, such as the example tiles 101 - 105 depicted in the array 100, each tile shown by a respective rectangular dashed box 101 - 105. The plurality of tiles may as shown have a substantially uniform footprint and be arranged in a plurality of rows "n" and columns "m". Each tile 101 - 105 may comprise one or more circuit blocks 13. In the illustrated example, each tile comprises four circuit blocks 13 arranged in a 2 x 2 layout. However, tiles may be formed by any number or combination (i.e., different types of circuits and active devices) of circuit blocks 13. In some examples, a single circuit block 13 may form a tile. In other examples each tile may comprise two circuit blocks 13, three circuit blocks, four circuit blocks , and so on.

The tile 101 in Fig. 2a comprises four exemplary circuit blocks 13, namely two circuit blocks 13a being CPU cores, and two circuit blocks 13b being memory circuits for instance of the type system level cache (SLC), (also known as last level cache (LLC)) memory slices. The floorplan areas (footprints) of the CPU cores 13a and the SLC slices 13b on the IC device 1 are matched to realize a symmetric tile structure, e.g., the footprint of the CPU cores and the SLC slices may by way of example be 500 x 500 micrometers. It should be appreciated that the symmetric tile structure is an example, and other tile structure arrangements such as asymmetric tiled structures are also possible.

In the above-mentioned tiled structure, the plurality of tiles are arranged such that peripheral regions are formed at boundaries or edges of tiles, such as boundaries 101a, 101b between adjacent tiles 101, 102, 103, 105 and so on. The peripheral region is thus formed for tile 101 by the intersection of boundaries 101a extending along the row direction (X direction) and boundaries 101b extending along the column direction (Y direction).

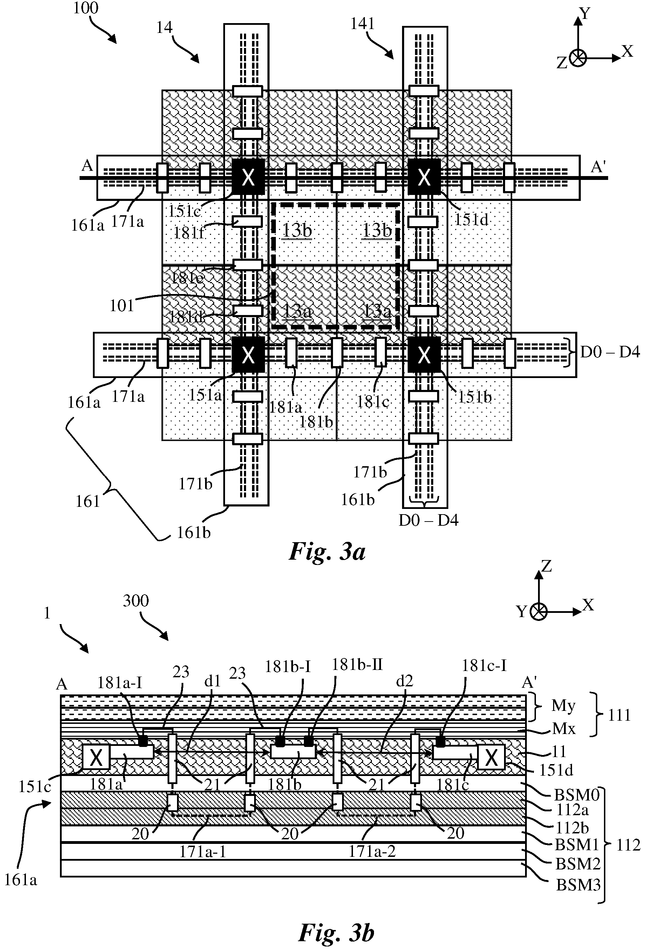

The IC device 1 further comprises a data communication circuit which will be further discussed below with further reference to Fig. 3a-b. As will be further described in the following, the data communication circuit is configured to transfer data between the plurality of circuit blocks 13. The data communication circuit comprises a plurality of switching circuits. Each switching circuit comprises a second set of active devices comprised in the active device tier 11 (not specifically shown in Fig. 1a-b). The second set of active devices are interconnected by the frontside interconnect structure 111. Each circuit block 13 of the IC device 1 is connected to the data communication circuit by a switching circuit. It should be appreciated that the circuit blocks arranged within a tile, may be connected to the data communication circuit by means of a switching circuit of or associated with the tile. In some implementations each of the plurality of circuit blocks may be connected to the data communication circuit directly by a switching circuit. Whereas, in some example implementations one or more circuit blocks of the plurality of circuit blocks may be connected indirectly to the data communication circuit, i.e., through a switching circuit connected to an intermediate component. The data communication circuit further comprises a plurality of data communication channels interconnecting the plurality of switching circuits. The plurality of data communication channels thus forms a plurality of data paths for transmitting data, e.g., data packets between the circuit blocks 13. Throughout this description, the data communication channels may also be referred to as routes or signal routes. The plurality of data communication channels comprise a plurality of backside interconnects that are arranged in one or more interconnect layers 112a, 112b of the backside interconnect structure 112. Each data communication channel of the IC device 1 comprises a respective subset of backside interconnects of the plurality of backside interconnects.

Example implementations of the data communication circuit will be described in further detail with reference to Figs. 3 - 5 below.

In the following and while explaining various components of the IC device 1 such as data communication circuits, etc., reference will be made to example array 100, the example tile 101, and the example circuit blocks 13, 13a, 13b arranged in the tile 101 for the sake of simplicity. However, it should be apparent that discussion applies correspondingly to each further tile and circuit block of the IC device 1, as well as other types and combinations of the circuit blocks 13 than the depicted CPU cores 13a and memory circuits 13b in tile 101.

Fig. 3a illustrates a schematic top view of a portion of array 100 of Fig. 2. The depicted portion of the array 100 comprises a 4 x 4 array having four rows and four columns of circuit blocks 13. In this implementation, the data communication circuit is a network-on-chip, NoC, circuit 141. Multiple cores of the IC device 1 are interconnected by the NoC circuit 141 implemented in a 2D mesh topology extending across a grid of crosspoint routers (X) with routing channels 161 there between. It is noted that as used herein, a "NoC circuit" refers to a network of routers, links between the routers, and interfaces between the routers and processing elements e.g., general purpose computing CPU cores or intellectual property (IP) cores, or memory circuit blocks, etc. The term "NoC circuit" may in particular refer to a mesh topology NoC circuit.

Each circuit block 13a, 13b of the tile 101 is connected to the NoC data communication circuit 141 by respective switching circuits 151a - d, i.e., NoC routers 151a - d. The plurality of data communication channels in the NoC circuit 141 are a set of NoC channels 161 comprising a first subset 161a of NoC channels and a second subset 161b of NoC channels. The first subset 161a of NoC channels extend in parallel in the row direction (X direction), and the second subset 161b of NoC channels extend in parallel in the column direction (Y direction) transverse to the row direction. It is noted that any additional number of NoC channels may extend in parallel in each direction, outside the depicted portion of the array 100. Accordingly, a mesh network for data transfer between the plurality of circuit blocks 13 is formed by the plurality of NoC channels.

As mentioned previously, the plurality of circuit blocks 13 are distributed in the row and column directions. Accordingly, the first and second subsets of NoC channels 161a, 161b are aligned with and extend along the rows and columns of the plurality of circuit blocks 13. Stated differently, the plurality of circuit blocks 13 are distributed in the row and column directions, along the first and second subset of NoC channels 161a, 161b. The plurality of circuit blocks 13 are arranged in the plurality of tiles, e.g., the tile 101. The first and second subset 161a, 161b of NoC channels are aligned with the peripheral region of the tile 101, i.e., extend along boundaries or edges 101a, 101b between adjacent tiles shown in Fig. 2.

The plurality of switching circuits in the NoC circuit 141 are NoC routers 151a - 151d. Each NoC router 151a - 151d comprises a second set of active devices, e.g., a second set of transistors, etc. (not specifically shown) comprised in the active device tier 11. The second set of active devices are interconnected by the frontside interconnect structure 111. Thus, the NoC routers 151a - d provide a network of routers for managing data traffic between the plurality of circuit blocks 13, wherein each router is configured to be connected to at least one corresponding circuit block 13, e.g., a processing unit or a memory circuit block of the IC device 1. Even though not identified specifically in Fig. 3a, the NoC routers 151a - 151d may be connected to respective processing units or memory circuit blocks 13a, 13b by means of respective I/O devices.

In the present context, NoC routers are network devices for enabling and managing data traffic between the multiple circuit blocks 13, such as multiple CPU cores 13a comprised in the IC device 1. A NoC router may utilize circuit switching and/or packet switching methods and protocols for managing data communication between various components on the IC device 1. Circuit switching establishes a dedicated communication path for the entire duration of a data transfer session, but at the cost of a more inflexible resource allocation. In contrast, packet switching divides data into data packets, each of which can traverse different data paths through the NoC mesh network to reach its destination that may be a CPU core, or an SLC slice, or a NoC router depending on the transferred data packets. The packet switching enhances flexibility and resource utilization in the NoC mesh for propagating data traffic. Further details of algorithms, protocols and methods for routing on-chip data traffic by NoC are presumed to be known to the skilled reader and will not be discussed further herein.

Each NoC router 151a - 151d is arranged at a respective crosspoint (X) between the first and second subset of NoC channels 161a, 161b. Only four exemplary NoC routers 151a - d are shown in Fig. 3a to be positioned at the intersections of the NoC channels 161a, 161b, corresponding to the corners of tile 101.

The plurality of NoC channels 161a, 161b interconnect the plurality of NoC routers 151a - 151d. More specifically, NoC channels 161a extending in the row direction connect NoC router 151a to NoC router 151b, and NoC router 151c to NoC router 151d. Similarly, NoC channels 161b extending in the column direction connect NoC router 151a to NoC router 151c, and NoC router 151b to NoC router 151d. This way, four data paths are formed for each NoC router in the mesh network for forwarding the data traffic.

Each NoC channel 161a, 161b comprises a plurality of data lines or signal routes, e.g., four data lines D0 - D4 shown by way of example for NoC channels 161a and 161b. Each data line D0 - D4 is arranged for connecting the NoC routers and transferring data signals between the plurality of NoC routers 151a - 151d. Each NoC channel 161a, 161b may for example comprise at least 16, 32, 64, 128, 256, 512, 1024, etc., number of data lines connecting the NoC routers.

The plurality of data communication channels 161a, 161b further comprise a plurality of backside interconnects. Accordingly, each of the plurality of NoC channels 161a comprises a respective subset 171a of the plurality of backside interconnects that extend in the row direction, and each of the plurality of NoC channels 161b comprises a respective subset 171b of the plurality of backside interconnects that extend in the column direction. The first and second subsets of backside interconnects 171a, 171b are shown in dashed lines forming part of the plurality of data lines D0 - D4 in each NoC channel 161a, 161b. The plurality of backside interconnects, i.e., the first and second subsets 171a, 171b are arranged in one or more interconnect layers 112a, 112b of the backside interconnect structure 112 shown in Fig. 1a-b.

Each of the one or more interconnect layers 112a, 112b of the backside interconnect structure 112 that comprises the plurality of backside interconnects may be realized as a bidirectional interconnect layer. By a bidirectional interconnect layer is here meant an interconnect layer which (unlike a conventional unidirectional interconnect layer) comprises metal lines extending both in the row direction (X direction) and in the column direction (Y direction) transverse to the row direction. Thus, the plurality of NoC channels 161a, 161a may be routed in a bidirectional mesh, such that NoC channels 161 extending in the row and column directions do not intersect outside of the crosspoints (where NoC routers are implemented) of the NoC mesh. Thus, both row and column directions in the same bidirectional interconnect layer 112a, 112b could route the data traffic, increasing routing resource utilization. In this way, a versatile signal routing scheme is devised wherein signal paths in both row and column directions or a combination thereof can be implemented within the same interconnect layer. This configuration also eliminates the need for including a via interconnect layer between two successive conventional unidirectional layers, as in case the NoC channels instead were implemented in separate unidirectional layers. Accordingly, a more efficient use of the available routing resources is achieved for implementation of backside interconnects for routing data traffic.

It should be appreciated that the backside interconnect structure may further comprise, in addition to the bidirectional interconnect layers 112a, 112b, one or more unidirectional interconnect layers. For instance, layers BSM1 - 3 may be implemented as regular unidirectional layers each extending in either the X or Y directions. The one or more unidirectional interconnect layers may for instance comprise at least a first and second backside interconnect layer BSM0 - 3 that are intended for implementing a PDN arranged in the backside interconnect structure.

In some example implementations, the plurality of backside interconnects of the communication channels may be arranged in two or more bidirectional interconnect layers of the backside interconnect structure 112.

Each data communication channel of the IC device 1 further comprises a plurality of repeater islands schematically indicated by rectangular boxes 181a-c. The repeater islands 181a-c are as shown arranged at intervals, e.g., with a regular spacing, along the data communication channel 16.

The repeater islands 181a-c are implemented to repeat and maintain signal quality of data signals propagating along the communication channels of the data communication circuit 14. The repeaters 181a-c may be implemented as any suitable type of repeater circuit to amplify and propagate data traffic. For instance, the repeaters 181a-c may be realized by inverter circuits with appropriate drive strength.

With reference to Fig. 3a, each portion of the NoC channels 161a, 161b extending along the edges of the tile 101 comprises respective repeater islands e.g., the depicted three repeater islands 181a - c are arranged between the NoC router 151a and 151b, and the three repeater islands 181d - f are arranged between routers 151a and 151c.

Each repeater island 181a - f comprises a third set of active devices, e.g., a third set of transistors, etc. (not specifically shown in Fig. 1a-b) that are comprised in the active device tier 11. The plurality of repeater islands of each respective NoC channel of the NoC circuit 141 are connected in sequence by a respective subset of the backside interconnects 171a, 171b of the respective NoC channel. Placement of the repeater islands on the floorplan is a design choice, and even if the repeater islands 181a - f are shown to be positioned at the peripheral regions of the tiles, in some example implementations, the repeater islands may be partially or entirely located within a footprint of a tile..

Fig. 3b depicts a schematic cross-sectional side view of a portion 300 of the IC device 1 taken along line A-A' extending along the communication channel 161a in example array 100.

Fig. 3b shows a first NoC router 151c and a second NoC router 151d. The communication channel 161a interconnects the first 151c and the second 151d NoC routers by the repeater islands 181a-c, and the backside interconnect portions 171a-1, 171a-2. The repeater islands 181a - c are arranged successively between the first 151c and the second 151d NoC routers. The distance between successive repeater islands may depend on e.g., the channel resistance, the drive strength of the repeater islands, etc. For example, the separation may be in the order of micrometers, e.g. 80 micrometers. In Fig. 3b repeater island 181a is arranged at a first distance d1 from the repeater island 181b, and the repeater island 181b is arranged at a second distance d2 from the repeater island 181c. While in the depicted example, the first distance d1 is substantially equal to the second distance d2, the repeater islands may also be arranged with an irregular spacing. The repeater islands 181a - c are connected in sequence by the respective portions of backside interconnects 171a-1, 171a-2 comprised in the NoC channel 161a. The first repeater island 181a is connected to the second repeater island 181b by means of a first backside interconnect portion 171a-1. The second repeater island 181b is in turn connected to the third repeater island 181c by means of a second backside interconnect portion 171a-2 of the backside interconnects 171a. Both interconnect portions 171a-1, and 171a-2 are arranged in the same backside interconnect layer 112b. While Fig. 3b depicts the NoC channel 161a as including only one metal line 171a-1, 171a-2 between each successive pair of routers, it should be noted that each NoC channel 161a may comprise multiple metal lines, e.g., such as 512 metal lines or more, each implemented in the one or more bidirectional interconnect layers 112a, 112b as previously explained.

As previously discussed, by this design of the IC device 1, the signal routing between the repeater islands 181a - c, which conventionally is performed using the My layers, is re-located to the backside interconnect layer 112a. This way the data traffic is routed from the first NoC router 151c to the second NoC router 151d, without occupying the My metal layers in the frontside interconnect structure 111.

In the illustrated implementation, since the backside interconnect portions 171a-1, 171a-2 arranged in the backside interconnect layer 112b are positioned at the backside 11b of the active device tier 11, vertical access is needed in order to form local connections between the active devices of each repeater island 181a - c and the backside interconnect portions 171a-1, 171a-2. Accordingly, via structures may be provided for routing signals vertically (in the Z direction) through the metal stack of the backside interconnect structure 112, to and from the active devices of the active device tier 11. For instance, within the backside interconnect structure 112, the first backside interconnect portion 171a-1 in the backside layer 112b may be interconnected to layer 112a through a first via structure 20, and to the BSM0 layer by another via structure (not individually shown). A second via structure 21 extending through the active device tier 11 e.g., a through-silicon via (TSV) structure, may connect the first backside interconnect portion 171a-1 to a local contact point 181a-I of the first repeater island 181a. Short distance signal lines 23 may be routed within the metal stack of the Mx layer of the frontside interconnect structure 111 between the second via structure 21 and the local contact point 181a-I of the first repeater island 181a. Similarly, the second 181b and the third 181c repeater islands are interconnected at their respective local contact points 181b-I, 181b-II and 181c-I through the respective first and second via structures 20, 21.

It is noted that the depicted portion of the IC device 1 is merely a simplified illustration to convey the example implementation of the backside interconnects and the data communication channels 161. Thus, details such as precise placement of repeater islands, via interconnects, or keep-out zones that are known in the art are neither specified nor depicted, as their structural and functional features are presumed to be available to the skilled person.

Next, an implementation of the IC device 1 wherein the data communication circuit is a ringbus circuit will be described with reference to Fig. 4. Fig. 4 shows a schematic top view of a portion of the floorplan of the IC device 1 as seen, e.g., from the frontside 11a of the active device tier 11 in Fig. 1a in absence of the frontside interconnect structure 111. The depicted portion comprises an array 200 of a plurality of circuit blocks 13, similar to array 100 in Figs. 2 and 3a.

The plurality of circuit blocks 13 of the array 200 are also distributed in the row direction (X direction) and the column direction (Y direction) extending transverse to the row direction. Accordingly, the plurality of computation circuit blocks 13 are arranged in the plurality of rows and columns of the array 200. Similar to array 100, the plurality of circuit blocks 13 in array 200 may be arranged in a plurality of tiles forming a tiled structure. The tiled structure comprises a plurality of tiles, such as the depicted tile 201 in the dashed rectangular box. The plurality of tiles are arranged in a plurality of rows and columns. Each tile comprises one or more circuit blocks 13. The tile 201 in array 200 comprises two example circuit blocks 13, namely one circuit block 13a being a CPU core, and one circuit block 13b being a memory circuit that in the depicted example may be an SLC memory slice.

As noted above, in the example of Fig. 4, the data communication circuit is a ringbus circuit 142. By ringbus circuit is herein meant a data communication circuit formed as a bus, wherein the topology of the bus is structured as a loop, wherein each tile is connected to two adjacent tiles through respective switching circuits. Accordingly, the ringbus circuit 142 may have a polygonal structure in a rectangular shape (e.g., as illustrated in Fig. 4), a square shape, an oval or circular shape, or the like.

In this example, array 200 comprises a 4x4 placement of circuit blocks 13 interconnected by the ringbus circuit 142. It should be appreciated that similar to array 100, array 200 may be of any dimensions and include any number of tiles according to the design parameters of the floorplan of the IC device 1. Each tile in array 200 may comprise one or more circuit blocks 13. The circuit blocks 13 comprised in respective tiles are connected to the ringbus circuit 142 by respective switching circuits of the tiles.

It is conceivable that in example implementations, a single ringbus circuit 142 may be implemented to interconnect all tiles implemented within the IC device 1. However, it is also possible that the ringbus circuit 142 further may comprise one or more additional ringbus circuits, such as a two, three, or more ringbus circuits. In other words, the data communication circuit may comprise a number of ringbus circuits 142, each ringbus circuit 142 being interconnected to a number of respective tiles The number of ringbus circuits may be implemented as local ringbus circuits or may be part of a global ringbus circuit with a global control unit, for instance, for synchronously controlling the operations and clock signals of all the ringbus circuits.

Similar to Fig. 3a, the implementation of the ringbus circuit 142 will be explained with reference to a single example tile, namely tile 201, and the circuit blocks 13a, 13b arranged in the tile 201, and their respective switching circuits .

Tile 201 comprises circuit blocks 13a, 13b and is connected to the ringbus data communication circuit 142 by a respective switching circuit 152a. Similarly, other example tiles are connected to the ringbus circuit 142 by their respective switching circuits 152b - 152f. In the depicted example tiles, the memory circuit 13b (e.g., SLC memory slice) which is co-integrated with respective CPU cores 13a of each tile provides the ringbus interface, i.e., connection to the switching circuits 152a - 152f. In this example topology, the plurality of switching circuits 152a - f may be centrally implemented within the footprint of the SLC slices 13b. In this way, the ringbus switches 152a - f are arranged external to the CPU cores 13a, similar to the crosspoints of the NoC routers in Fig. 3a. The ringbus switches 152a - 152f manage and control the flow of data traffic from the interconnected CPU cores 13a. However, it should be appreciated that placement and co-integration of the switching circuits 152a - f in the ringbus circuit 142 will depend on the intended architecture and topology of the designed IC device 1 comprising the ringbus circuit 142. The data traffic flow as forwarded by the several nodes within a ringbus circuit may be in two directions, i.e. either in a clockwise or in an anti-clockwise direction.

The plurality of data communication channels 162 in the ringbus circuit 142 may be comprised in a plurality of ringbus segments, e.g., segments 162a, 162b, 162c as depicted here. Stated differently, the ringbus circuit 142 may comprise a plurality of segments interconnecting the switching circuits and the circuit blocks 13 of the IC device 1. In the rectangular ringbus 142 a segment may be a portion of the ringbus circuit 142 extending between and connecting two adjacent switching circuits such as the segment 162a (extending in the column direction) connecting the switching circuits 152a and 152b. Similarly, segment 162b (extending in the row direction) connects two adjacent switching circuits 152c and 152d or 152a and 152g. However, a segment may also be understood as a portion of the ringbus circuits that comprises and connects a plurality of the switching circuits. For instance, segment 162c (extending in the column direction) connects switching circuits 152d, 152e, 152f, and 152g placed along the right arm of the ringbus circuit 142. In some implementations each switching circuit is arranged between two adjacent ringbus segments such as switching circuit 152d arranged between segments 162b and 162c. In several example embodiments, each ringbus channel 162 may comprise at least 16, 32, 64, 128, 256, 512, 1024, etc., number of data lines connecting the ringbus switches.

Each data communication channel 162 of the IC device 1 with the ringbus circuit implementation comprises a plurality of backside interconnects arranged in one or more bidirectional interconnect layers of the backside interconnect structure 112. Accordingly, a respective subset, e.g., subsets 172a, 172b, 172c of backside interconnects of the plurality of backside interconnects is arranged in respective ringbus communication channels, i.e., ringbus segments, e.g., segments 162a, 162b, 162c. Each ringbus channel 162a, 162b, 162c comprises a plurality of data lines or signal routes, e.g., four data lines D0 - D4 shown by way of example for ringbus channel 162c. Each data line D0 - D4 is arranged for connecting the ringbus switches and transferring data signals there between.

The data communication channels 162 in the ringbus circuit topology also comprise a plurality of repeater islands arranged at intervals along each data communication channel 162. For instance, three example repeater islands 182a - c are arranged within the segment 162b of the ringbus circuit 142. The repeater islands 182a - c are arranged between the switching circuit 152c and 152d, in segment 162b extending in the column direction.

Each repeater island comprises a third set of active devices (not specifically shown in Fig. 1a-b) that are comprised in the active device tier 11. The plurality of repeater islands of each data communication channel 162 in the ringbus circuit 142, e.g., in the communication channels 162a, 162b and 162c are connected in sequence by the respective subset of backside interconnects 172a, 172b, 172c comprised in that ringbus segment 162a, 162b, 162c.

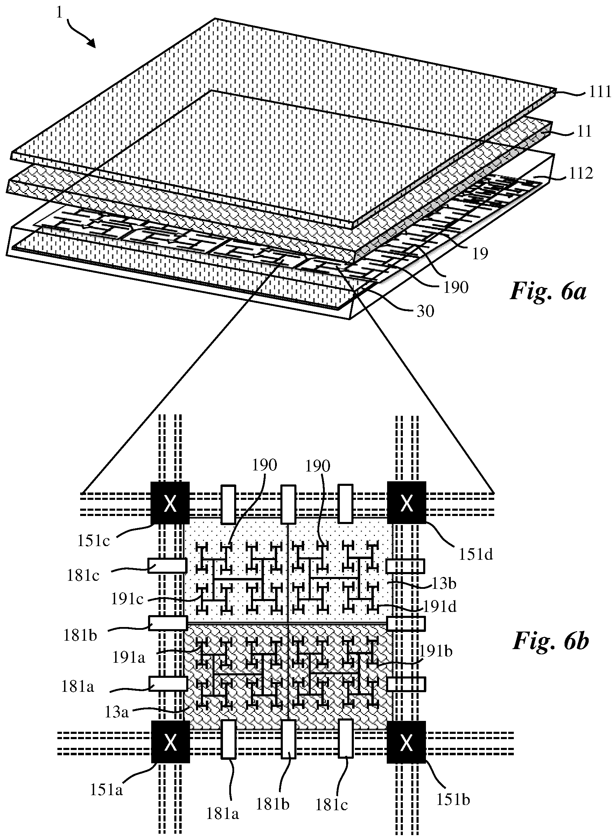

According to some implementations, also clock distribution within the IC device 1 may be routed in the backside interconnect structure 112. Accordingly, with further reference to Fig. 6a, the IC device 1 may further comprise a clock distribution network 19. The clock distribution network 19 is arranged in one or more interconnect layers 112a, 112b of the backside interconnect structure 112. A common implementation of the clock distribution network is a clock tree, such as an H-tree 191a - 191d shown in Fig. 6b.

The clock distribution network 19 comprises a plurality of backside clock interconnects 190 arranged in the one or more interconnect layers 112a, 112b of the backside interconnect structure 112. The plurality of backside clock interconnects are connected to the plurality of circuit blocks 13 to distribute clock signals to the plurality of circuit blocks 13 such as CPU cores. The clock network 19 may comprise a fourth set of active devices, e.g. a fourth set of transistors, etc. (not specifically shown in Fig. 1a-b) comprised in the active device tier 11. The active clock devices may be any transistor-based device of the clock distribution network, such as a clock driver, a clock repeater, a clock gate or a clock buffer (non-inverting or inverting).

Reverting to Figs. 2, 3a and 4, each tile in the tiled structure of the IC device 1 e.g. tile 101 in the IC device 1 with the NoC circuit 141 or tile 201 in the IC device 1 with the ringbus circuit 142 may be associated with a respective portion of the clock distribution network 19, i.e., a designated portion of the clock distribution network 19 being connected to the one or more circuit blocks 13 of that tile 101; 201. In the example implementation of Fig. 6b, the tile 101 of Fig. 3a is depicted with its respective portions 191a - 191d of the clock distribution network 19. Each of the one or more circuit blocks 13a, 13b of the tile 101, has a respective portion of the clock distribution network 191a - 191d connected to it, within the footprint of the circuit blocks 13a, 13b. Each portion of the clock distribution network 19 is implemented as a clock tree 191a - 191d. Clock trees 191a - 191d include clocking circuitry and active devices for distributing clock signals to the circuit blocks 13.

It should be appreciated that a portion of the clock distribution network may be connected to multiple circuit blocks 13 within the footprint of the tile 101. For instance, each circuit block 13 need not have a dedicated clock portion and may share a clock tree with an adjacent circuit block. Therefore, other configurations and connections of the portions of the clock network 19 to the circuit blocks 13 than the depicted example can be readily discerned by the skilled person. In some implementations, the respective portion 191a - 191d of the clock distribution network 19 for each tile may be arranged in the two or more bidirectional metal layers of the backside interconnect structure 112, within the footprint of the tile 101.

With reference to Fig. 3b, it should be appreciated that the backside clock interconnects 190 of the clock distribution network 19 in the IC device 1 are implemented in a corresponding manner as the backside interconnects. Stated differently, the backside clock interconnects 190 are routed in the bidirectional interconnect layers 112a, 112b of the backside interconnect structure 112. The backside clock interconnects 190 are interconnected to conductive elements in the active device tier 11, or the frontside interconnect structure 111, active clock devices such as clock repeaters, or the local contacts of the circuit blocks 13 e.g., clock inputs of CPU cores 13a, through corresponding via interconnects (not specifically identified) for routing the clock signals throughout the IC device 1.

Advantageously, the backside clock interconnects may be arranged in two or more bidirectional layers 112a, 112b of the backside interconnect structure 112 as will be described with reference to Fig. 5 below.

In addition to backside routing of data traffic, implementing backside clock signal routing further reduces the competition for routing resources in the frontside interconnect structure. Moreover, arranging the clock distribution network 19 in the two or more layers 112a, 112b of the backside interconnect structure 112 allows for efficient backside routing of the clock signals in the same bidirectional layers of the backside interconnect structure utilized for implementation of backside interconnect structures of the NoC 141 or ringbus 142 circuits. Thanks to this spatial separation between the clock trees and the data communication channels, the clock H-trees and NoC or ringbus interconnects implemented in the same bidirectional layers have non-overlapping footprints. Accordingly, the available routing resources of the bi-directional backside layers 112a, 112b not used for the data communication channels are utilized more efficiently.

In several exemplary embodiments, the IC device 1 may further comprise a PDN 30 arranged in the backside interconnect structure 112 as schematically identified in Fig. 6a. The power distribution requires metal lines with low resistance to minimize the IR drop, i.e., a voltage drop across the PDN. The backside metal stack 112 is hence optimized for a low resistance PDN and formed with more relaxed pitches compared to the frontside layer Mx of the frontside interconnect structure 111. As realized by the present inventors, since the NoC or ringbus channel routes also require a low unit RC to drive long wires at a high clock frequency, the NoC and ringbus routes may advantageously be co-integrated in the backside interconnect structure, alongside the backside PDN.

In this way, the inter-core signal routing of the NoC circuit 141 or ringbus circuit 142, and the power distribution for the PDN 30 may all advantageously be offloaded from the frontside BEOL to the backside interconnect structure 112. The power or supply voltage rails of the IC device 1 (e.g., VDD and VSS) may thus be arranged in the backside interconnect structure 112, e.g., as backside power rails of the backside PDN 30. In some implementations, the backside PDN 30 may be arranged in at least a first and second backside interconnect layer, e.g. BMSO - 3. The one or more interconnect layers 112a, 112b of the backside interconnect structure 112 comprising the plurality of backside interconnects of the communication channels and/or the plurality of backside clock interconnects 190 may be arranged between at least the first and second backside interconnect layers BMSO - 3. For example, VDD and VSS rail structures connecting to the circuit cells (e.g., standard cells) of the IC device 1 may be defined in BSM0 layer of the backside metal stack 112 in Figs. 1a and 1b, and metal conductors included in the backside layers BSM1 - 3 may route other parts of the PDN network 30. It should be appreciated that the number of PDN layers arranged above or below the bidirectional interconnect layers 112a, b routing the data traffic and clock networks may be different than what is depicted in the figures. For instance, instead of only layer BSM0 is arranged above the layers 112a, b, two PDN layers such as BSM0 and BSM1 may be arranged on top, and the rest of the PDN layers e.g., BSM2, BSM3, etc. may be arranged underneath the data and clock routing layers 112a, b. The backside layers BMSO - 3 may be unidirectional layers.

The co-integration of the NoC or ringbus channels alongside the backside PDN in the backside metal stack 112 disclosed herein is estimated to provide a lower wafer cost for the same signal count in the data communication channels with insignificant IR drop penalty.

Fig. 5 illustrates a portion 400 of the IC device 1 according to a further implementation. The portion 400 is also explained with reference to the NoC circuits 141 and the NoC channels 161, however is analogously compatible with implementations when the data communication circuit is the ringbus circuit 142.

In this example, in contrast to portion 300 of Fig. 3b, the subset 171a of backside interconnects of the NoC channel 161a is routed in two successive backside interconnect layers 112a and 112b of the backside layer 112b extending in the row direction. In other words, each layer 112a, 112b comprises a respective portion of the subset of backside interconnects 171a, namely, backside interconnects 171a' implemented in layer 112a and backside interconnects 171a" implemented in layer 112b.

Compared to implementing the backside interconnects 171a in only one bidirectional layer, by the present implementation the width of the NoC channel 161a is advantageously reduced by around 50%, which in turn alleviates constraints on the dimensions (e.g., width requirements) of the repeater islands to be integrated in the floorplan of the IC device 1, thus further optimizing the area penalty for signal routing.

Moreover, co-integrating the clock distribution network 19 in the backside interconnect structure 112, in at least two bidirectional backside interconnect layers 112a, 112b will allow for a more technically feasible, robust and efficient implementation, taking into account any routing irregularities of the clock interconnects 190 imposed due to the chip design requirements. Using three successive bidirectional interconnect layers (not specifically shown) further accentuates the above-mentioned advantages.

Reverting to Fig. 5, two exemplary repeaters 18a and 18b of a repeater island are depicted disposed adjacent to each other. The routing layers of the Mx layer of the frontside interconnect structure 111 may be denoted M0, M1, M2, M3, and so on, respectively, where the M0 routing layer is shown to be the first routing layer positioned on the active device tier 11.

The repeater 18a is connected at its first contact points 18a-I, 18a-II through a short distance metal line 23a in the M1 layer of the Mx routing layer and respective via interconnects 20, 21 to the backside interconnect structure 112, and more specifically to the interconnect layer 112b, where backside interconnects 171a" are implemented.

Accordingly, data traffic in the associated NoC channel and between the NoC routers that is to be amplified and propagated by the repeater 18a will be routed by the backside interconnects 171a" in layer 112b, which may connect the repeater 18a to another successively positioned repeater island (not shown). Similarly, the repeater 18b is connected to the backside interconnects 171a' in layer 112a for routing the data traffic in the associated NoC channel. This way each bidirectional interconnect layer 112a, 112b is populated by the respective portion of the backside interconnects 171a', 171a" for routing NoC signals, allowing further functionalities such as clock signal routing to be disintegrated much more efficiently to the interconnect layers of the backside interconnect structure 112.

To this end, the backside interconnect structure 112 may comprise further structures, e.g., via interconnect layers denoted Vx routing signals between the interconnect layers 112a, 112b as well as other stack layers BSM0 - BSM3 within the backside interconnect 112. These backside layers and via interconnect layers may be utilized for implementing other components of the IC device 1 such as the clock distribution network 19 or the PDN 30.

Design and fabrication of the active device tier comprising the active devices, the frontside interconnect structure or the backside interconnect structure in the above-described aspects and embodiments may be realized by any process techniques known in the art and has not been discussed herein to avoid obscuring the scope of the present invention.

The person skilled in the art realizes that the present invention by no means is limited to the examples described above. On the contrary, many modifications and variations are possible without departing from the scope of the appended claims. For instance, while in the above illustrated examples the active device tier 11 is schematically shown as a single layer, it is to be noted that the active device tier 11 may comprise multiple layers each comprising active regions with respective contact layers, respective interconnect layers such as via interconnect layers and so on. Furthermore, even though only one IC device has been illustrated and discussed, the IC device may comprise a die stack with a second die arranged above or below the first die, while each of the first and the second dies comprises a plurality of respective circuit blocks, data communication circuits, and other device components disintegrated to a backside interconnect structure of that die. In some example implementations, the first die and the second die may be interconnected by means of multilevel via interconnect structures in a 3D die stack arrangement.

## Claims

1. An integrated circuit device (1) comprising:
an active device tier (11) and a frontside interconnect structure (111) arranged at a frontside (1 1a) of the active device tier and a backside interconnect structure (112) arranged at a backside (11b) of the active device tier;
a plurality of circuit blocks (13), each comprising a first set of active devices comprised in the active device tier (11), the first set of active devices being interconnected by the frontside interconnect structure (11);
a data communication circuit configured to transfer data between the plurality of circuit blocks;
wherein the data communication circuit is a network-on-chip, NoC, circuit (141) or a ringbus circuit (142); and
wherein the data communication circuit comprises:
a plurality of switching circuits (151a - 151d, 152a - 152f), each comprising a second set of active devices comprised in the active device tier (11), the second set of active devices being connected by the frontside interconnect structure (111), wherein each circuit block is connected to the data communication circuit by a switching circuit; and
a plurality of data communication channels (161, 162) interconnecting the plurality of switching circuits and comprising a plurality of backside interconnects (171a, 171b, 172a - 172c) arranged in one or more interconnect layers (112a, 112b) of the backside interconnect structure.

2. The integrated circuit device (1) according to any one of claim 1, wherein each data communication channel comprises:
a respective subset of backside interconnects (171a, 171b, 172a - 172c) of the plurality of backside interconnects, and
a plurality of repeater islands (181a - 181c, 182a - 182c) arranged at intervals along the data communication channel (161, 162), each repeater island comprising a third set of active devices comprised in the active device tier (11), and
wherein the repeater islands of the data communication channel are connected in sequence by the respective subset of backside interconnects.

3. The integrated circuit device (1) according to any one of claims 1 or 2, wherein the data communication circuit is the NoC circuit (141), and the plurality of data communication channels are a set of NoC channels (161) comprising a first (161a) and second (161b) subset of NoC channels,
wherein the first subset of NoC channels extend in parallel in a row direction, and the second subset of NoC channels extend in parallel in a column direction transverse to the row direction.

4. The integrated circuit device (1) according to claim 3, wherein the plurality of circuit blocks are distributed in the row and column directions, along the first and second subset of NoC channels.

5. The integrated circuit device (1) according to any one of claims 3 or 4, wherein the plurality of circuit blocks are arranged in a plurality of tiles (101 - 105), the plurality of tiles being arranged in a plurality of rows and columns, and wherein the first and second subset of NoC channels (161a, 161b) extend along boundaries between the tiles.

6. The integrated circuit device (1) according to any one of claims 3 - 5, wherein the plurality of switching circuits (15) are NoC routers (151a - 151f), each NoC router being arranged at a respective cross-point (X) between the first and second subset of NoC channels (161a, 161b).

7. The integrated circuit device (1) according to any one of preceding claims, wherein each of the one or more interconnect layers (112a, 12b) of the backside interconnect structure (112) comprising the plurality of backside interconnects (171a, 171b, 172a - 172c) is a bidirectional interconnect layer comprising metal lines extending in a row direction and in a column direction transverse to the row direction.

8. The integrated circuit device (1) according to any one of preceding claims, wherein the plurality of backside interconnects (171a, 171b, 172a - 172c) of the communication channels are arranged in two or more bidirectional interconnect layers (112a, 112b) of the backside interconnect structure comprising metal lines extending in a row direction and in a column direction transverse to the row direction.

9. The integrated circuit device (1) according to any one of the preceding claims, wherein the integrated circuit device further comprises:
a clock distribution network (19) comprising a plurality of backside clock interconnects (190) arranged in the one or more interconnect layers (112a, 112b) of the backside interconnect structure (112) and connected to the plurality of circuit blocks (13) to distribute clock signals to the plurality of circuit blocks.

10. The integrated circuit device according to claim 9, wherein the plurality of backside clock interconnects (190) are arranged in the two or more bidirectional interconnect layers.

11. The integrated circuit device according to claim 10, wherein the clock distribution network comprises, for each tile (101 - 105), a respective portion (191a - 191d) of the clock distribution network arranged in the two or more bidirectional metal layers (112, 112b) of the backside interconnect structure (112), within a footprint of the tile, and being connected to one or more circuit blocks of the respective tile.

12. The integrated circuit device (1) according to any one of claims 1 or 2, wherein the data communication circuit is the ringbus circuit (142);
wherein the plurality of communication channels (162) are comprised in a plurality of ringbus segments (162a - 162c), and wherein a switching circuit (152a - 152f) is arranged between two adjacent ringbus segments.

13. The integrated circuit device (1) according to any one of the preceding claims, further comprising a power distribution network (30) arranged in the backside interconnect structure (112).

14. The integrated circuit device (1) according to claim 13, wherein the power distribution network (30) is arranged in at least a first and second backside interconnect layer (BSM0 - BSM3), and wherein the one or more interconnect layers (112a, 122b) of the backside interconnect structure (112) comprising the plurality of backside interconnects (171a, 171b, 172a - 172c) of the communication channels (161, 162) are arranged between at least the first and second backside interconnect layers.

15. The integrated circuit device (1) according to any one of preceding claims, wherein the integrated circuit device comprises a die (2) having a backside (2a) and a frontside (2b); and
wherein the active device tier (11) is arranged on the frontside of the die, and the backside interconnect structure (112) is arranged opposite the active device tier (11) on the backside (2b) of the die.
